# EUROPEAN PATENT APPLICATION

(11) **EP 3 633 302 A1**
(43) Date of publication of application: **08.04.2020**
(21) Application number: 18197860.2
(22) Date of filing: 01.10.2018
(51) Int. Cl.: F28D 15/02, H01L 23/427, H05K 7/20

(54) **HEAT EXCHANGER AND METHOD OF MANUFACTURING A HEAT EXCHANGER**

(71) Applicant: ABB Schweiz AG, 5400 Baden (CH)
(72) Inventor: Manninen, Jorma, 00380 Helsinki (FI); Silvennoinen, Mika, 00380 Helsinki (FI); Pakarinen, Joni, 00380 Helsinki (FI)
(74) Representative: Kolster Oy Ab

(57) **Abstract**

A method of manufacturing a heat exchanger and a heat-exchanger comprising a base chamber (11) and one or more condensers (12). The base chamber (11) comprises a top surface (13), a bottom surface (14) and side walls (15) attached to the top surface and the bottom surface, the top surface being adapted to receive one or more heat generating components and the bottom surface comprising one or more elongated openings (16) and the one or more condensers (12) are formed to the bottom surface (14) of the base chamber, extend from the bottom surface and are closed structures having an opening corresponding to the openings of the bottom surface such that the base chamber (11) forms together with the one or more condensers a gas-tight structure having a working fluid enclosed inside the volume of the structure.

## Description

### FIELD OF THE INVENTION

The invention relates to a heat exchanger, and particularly to a two-phase heat exchanger for cooling electrical components.

### BACKGROUND OF THE INVENTION

Power electronic switches are capable of switching high currents with high voltages. The currents can be in the range of hundreds of amperes with the operating voltages of over thousand volts. During each switching instant heat is generated in the component and this generated heat should be removed from the component. Power electronic components are also arranged in power electronic modules in which multiple of components, such as switches, are internally wired for certain applications.

Power electronic modules' heat loss is dissipated mainly via its few millimeter thick copper baseplate or via substrates' bottom in case of so called baseplate-less component. The bottom of the baseplate or the substrate has to be in good thermal connection with a cooling device like air cooled heatsink, liquid cooling cold plate or a thermosyphon heatsink. It is clear that thermal characteristics of the cooling device have to be designed according to both the power electronic module and its usage profile.

Frequency converters or inverters operated in a high speed motor drive has increased power electronic module heat losses because of higher switching frequency and output current. Then high power cyclic applications have higher temperature cycling induced mechanical stresses within the power electronic module. Conventional heatsinks' thermal characteristics are well known and utilized quite well too. However, it is clear that the increasing heat loss density (W/cm2) of next generation high-end power electronic modules require more efficient cooling solutions. Also, the common aluminum heatsinks' time constants are insufficient for the high power cyclic applications that results excessive module chip temperatures and reduced module service life. Much faster cooling response is needed to achieve efficient and reliable end product and customer satisfaction.

Specific heatsink and heat exchanger designs have been developed to address the above mentioned challenges over time. These cooling improvements relate e.g. to special cooling fin designs for enhanced surface area and/or enhanced heat transfer coefficient, combination of different construction materials such as Aluminum and Copper, and use of two-phase heat transfer using heat-pipes vapor chambers. Especially the two-phase heat transfer assisted cooling solutions have proven to be efficient, lightweight and compact and to provide design freedom.

The common heatsink design problem related to insufficient cooling fin efficiency. Aluminum is relatively inexpensive material and easy to manufacture but its thermal conductivity (k∼200 W/mK) is often insufficient. Then copper fins or base plate inserts (k∼380 W/mK) are commonly considered but this increases the total weight and cost significantly.

### BRIEF DESCRIPTION OF THE INVENTION

An object of the present invention is to provide a heat exchanger and a method of manufacturing a heat exchanger so as to solve the above problems. The objects of the invention are achieved by a heat exchanger and a method which are characterized by what is stated in the independent claims. The preferred embodiments of the invention are disclosed in the dependent claims.

The invention is based on the idea of forming a heat exchanger with two-phase heat transfer having a base chamber and one or more condensers. The base chamber has a surface for attaching heat sources, such as power electronic components or a power electronic module, and one or more condensers extend form the base chamber. Further, the one or more condensers extend in the surface of the base chamber such that the length of the one or more condensers in the direction of the surface of the base chamber is relatively large. Preferably, the length of the one or more condensers correspond to the length of the base chamber.

The heat exchanger of the invention provides improved cooling and fast response to rapidly increasing temperatures. This is due to relatively large condensing surface area which the vapour can access easily. Further, cooling fins may be placed in various positions to further improve the heat transfer.

In the method of the invention, the heat exchanger is formed of a sheet metal plate which is folded to form a desired shape. After the metal plate is folded, sidewalls and top surface are attached to form a closed structure. Prior to folding, the sheet metal plate is equipped with support structures, which when folded, support the structure mechanically such that a rigid heat exchanger is formed. The method of the invention enables manufacturing of an efficient heat exchanger in a simple manner.

### BRIEF DESCRIPTION OF THE DRAWINGS

In the following the invention will be described in greater detail by means of preferred embodiments with reference to the attached drawings, in which
Figure 1 shows a cross section of an embodiment of the invention;
Figure 2 shows a perspective view of an embodiment of the invention;
Figure 3 and 4 show an embodiment of a method of the invention;
Figures 5, 6, 7 and 8 show various embodiment of the invention.

### DETAILED DESCRIPTION OF THE INVENTION

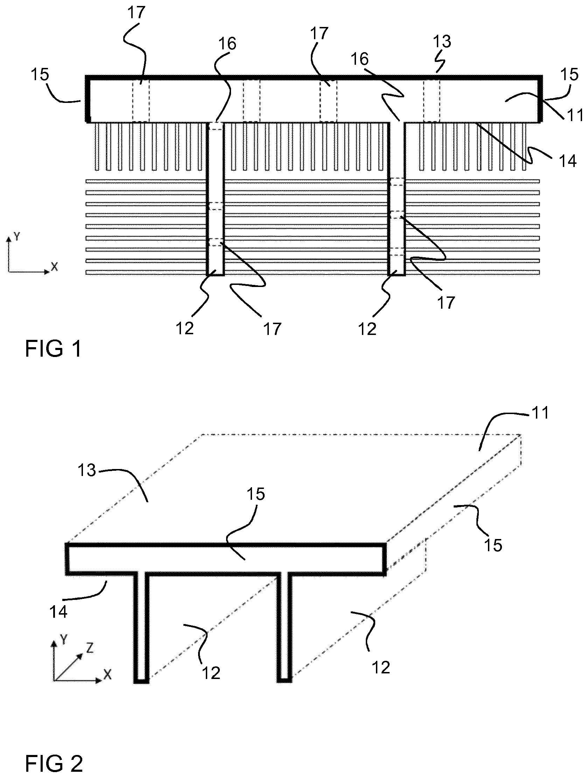

Figure 1 shows an embodiment of the heat exchanger of the invention. The heat exchanger comprises a base chamber 11 having a top surface 13, a bottom surface 14 and side walls 15 which form a closed structure. Further, the heat exchanger comprises one or more condensers 12 which are formed to extend from the base chamber. The base chamber together with the one or more condensers form a closed and gas-tight structure which encloses a working fluid for two-phase heat transfer.

In the embodiment of Figure 1 the heat exchanger has two condensers 12. However, the number of the condensers may be one or any number greater than one. The condensers extend from the bottom surface of the base chamber and have an opening to allow the working fluid to flow inside the heat exchanger freely between the base chamber and the condensers.

In the embodiment of Figure 1, the heat exchanger is further equipped with cooling fins which are shown to be attached both to the bottom surface of the base chamber and to the condensers.

As seen in Figure 2, which is a perspective view of the heat exchanger of Figure 1 without the cooling fins, the condensers extend in the direction of length Z of the base chamber. Therefore the base chamber comprises one or more elongated openings and the condensers have a corresponding openings such that the base chamber and the condensers form an uniform closed space in which the working fluid is able to flow freely. According to an embodiment the one or more elongated openings of the bottom surface have a width and a length corresponding to the openings of the one or more condensers. Further, according to an embodiment the one or more condensers extend from the bottom surface of the base chamber in the direction perpendicular to the top surface of the base chamber.

The cross-section of the one or more condensers has a polygon shape, and in a preferred embodiments the cross-section of the one or more condensers is rectangular. As shown in the embodiment of Figure 2, the base chamber is a box-like structure having a length in Z direction, a width in X direction and a height in Y direction. Correspondingly, the one or more condensers are also box like structures with one open side. The condensers and the base chamber are joined such that the open sides of the condensers are towards the bottom of the base chamber. The bottom of the base chamber has elongated openings in the places where the condensers are joined to the base chamber. As places of the elongated openings and the open side of the condensers are aligned, a single volume is formed of the volumes of the base chamber and the one or more condensers.

The embodiment of Figure 1 also shows support structures 17 such as pillars inside the base chamber and the one or more condensers. These support structures are placed inside the heat exchanger to provide mechanical strength to the structure.

The top surface 13 of the base chamber is adapted to receive a heat generating component, such as a power electronic module. The top surface is thus the heat receiving surface. A two phase heat exchanger comprises a working fluid inside the volume of the heat exchanger. The working fluid may be, for example, distilled water. When a heat generating component attached to the top surface produces heat, the working fluid inside the heat exchanger starts to warm up and eventually evaporates gas. The gas flows to cooler places inside the heat exchanger and condenses back to liquid. When the operating fluid changes its phase it absorbs and releases heat, that is, when the heat generating component heats the working fluid, it evaporates and absorbs heat and transfers it to a cooler place inside the structure. As the gas ends in a cooler place, it again condenses and releases heat. The fluid inside the structure evaporates below the top surface of the base chamber and further condenses in the bottom surface of the base chamber and in the one or more condensers. The condensers and the bottom surface of the base chamber are preferably equipped with cooling fins so as to further remove the heat from the heat exchanger to the surrounding atmosphere.

The base chamber and the one or more condensers are referred to as different parts of the heat exchanger in a functional manner. That is, the base chamber and the one or more condenser may be formed in a single manufacturing process and the one or more condensers does not necessarily require any separate attachment steps as will be described later. Similarly, the elongated opening in the base chamber may be formed together with the formation of the one or more condensers.

According to an embodiment, the base chamber and the one or more condensers comprise a surface treatment for efficient liquid transport inside the heat exchanger. Such a surface treatment is preferably a wick structure formed to the inner surfaces of the base chamber and the one or more condensers.

The material of the heat exchanger is preferably copper and specifically high quality oxygen free copper. As known, copper has good thermal properties and found to be suitable as the material of the heat exchanger. The material of wick structure formed to the inner surface of the heat exchanger is preferably copper and formed to the inner surface if form of copper mesh or copper powder using high quality oxygen free copper.

The wall thickness of the top surface is preferably in the range from 3 mm to 7 mm. The thickness of the wall of the top surface can be used a design parameter in optimizing the heat transfer depending on the heat generating component and its operation.

The one or more condensers cross section geometry is preferably rectangle. However, the geometry is not limited to rectangle but can be varied depending on the design. The wall thickness of the one or more condensers is preferably in the range of 1 mm to 3 mm. The embodiments shown in Figures 1 and 2 show two condenser. However, the number of the condensers is not limited. According to an embodiment, the one or more condensers extend between opposite edges of the base chamber. The length of the one or more condensers in the Z direction is typically close to the length of the base chamber. However, the length may also be shorter than the length of the base chamber. The Z direction of the one or more condensers is typically the longest dimension of the one or more condensers, i.e. the direction to which the one or more condensers extend in the surface of the base chamber.

The length of the one or more condensers and their position in the base chamber surface in X direction can vary as they may be designed according to the requirements of the cooling case in question. The X direction is the direction of normal of the Z direction.

Further, as shown in Figure 1, the one or more condensers are preferably equipped with cooling fins or the like which extend the cooling surface. As in the connection with the base chamber, the one or more condensers are of copper, and preferably of high quality oxygen free copper. Further, a suitable wick material for enhancing the liquid circulation is copper powder or copper mesh, and preferably sintered high quality oxygen free copper powder or copper mesh.

The cooling fins attached to the bottom surface of the base chamber and the one or more condensers are preferably prepared from copper sheet material having a thickness of 0,5 mm.

In the above, the material of the heat exchanger is described as being copper. However, multiple of other construction materials are available. The heat exchanger or parts of heat exchanger of the present disclosure can formed of other metals such as aluminum or titanium. In general the selection of the material of the heat exchanger is related to several issues like compatibility with working fluid, cooling requirements, such as total heat load (Watts) and maximal heat flux (Watts / cm²), and mechanical strength requirements.

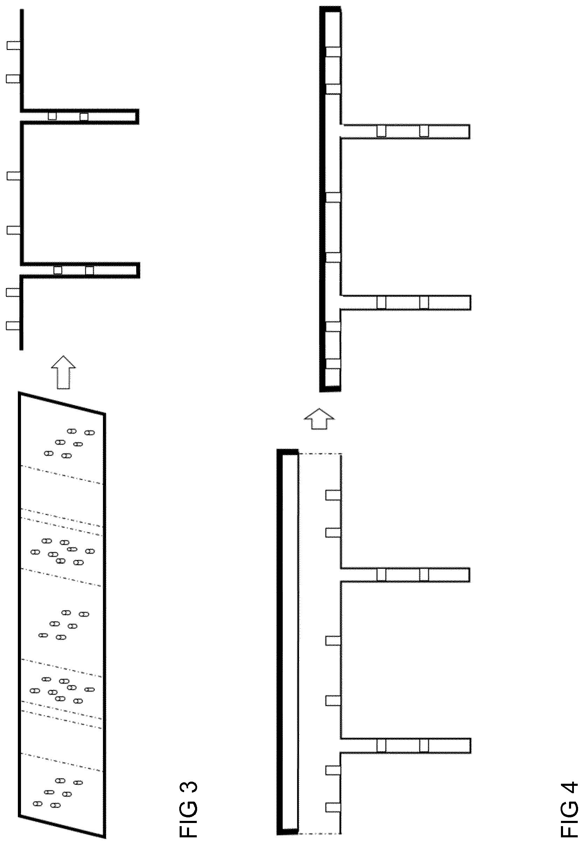

The method of the invention for manufacturing a heat exchanger comprises providing a rectangular metal sheet and providing supporting structures to a surface of the rectangular metal sheet. Figure 3 shows an example of a rectangular metal sheet having supporting structures, such as pillars, attached to the surface of the sheet. Further in the method the rectangular metal sheet is formed to produce one or more condensers and a bottom surface of a base chamber. In Figure 3 it is further shown the metal sheet as formed to produce two condensers and a bottom surface of a base chamber. The support structures are shown to be situated inside the condensers and on top of the bottom surface of the base chamber. The support structures or pillars are dimensioned such that when the metal sheet is formed, the pillars are in contact with both sides of the condensers.

Further in the method, a metal part forming a top surface and the side walls of the base chamber is formed. This metal part is shown in Figure 4 together with the formed metal sheet. The formed metal part is further attached the formed rectangular metal sheet to form a structure as shown in right side of Figure 4. The metal pillars are shown inside the base chamber to provide support to the structure.

Further, as the ends of one or more condensers are still open, the open ends of the one or more condensers are sealed with metal sheets. As it is understood, the formed metal sheet forms only the sides and lower end of the condensers, the open ends need to be furnished with metal sheets to obtain a closed structure.

According to an embodiment of the method, a wick structure is produced to the surface of the rectangular metal sheet. When the heat exchanger is assembled as described above, the wick structure is formed inside the heat exchanger is desired manner.

The metal part attached forming the top surface of the base chamber is preferably formed from a thicker metal than the metal material of the sheet which forms the bottom surface and the one or more condensers. Further, the metal part may also include wick structure.

The metal used for manufacturing a heat exchanger is preferably copper, aluminum or titanium. The method and its embodiments are further described here in connection with embodiments in which the metal is copper. The manufacturing method is similar with other metals, and here copper is used as an example. The separate metal, such as copper, aluminum or titanium parts are preferably attached to each other by laser welding or soldering. That is, the top surface of the base chamber and the formed copper sheet are preferably laser welded or soldered and the metal sheets used for sealing the structure are also preferably laser welded or soldered.

Further, according to an embodiment, cooling fins are attached to the outside surfaces of the bottom surface of the base chamber and the one or more condensers. The cooling fins are preferably of copper and are laser welded or soldered to the structure of the heat exchanger.

Alternatively, the heat exchanger may be manufactured by manufacturing first the base chamber part from two metal plates that are soldered together. Prior to soldering the cooling fluid wick structure and possible mechanical support structures are processed by, for example, brazing or sintering to the plates. The one or more condenser parts are manufactured similarly to the above mentioned base chamber part. Further, the base chamber and the condensers are joined together by soldering and the cooling fins are attached as described above.

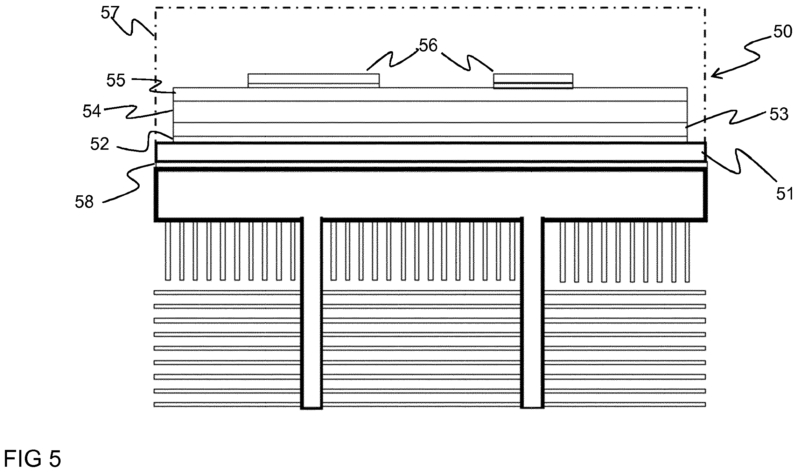

Figure 5 shows an example in which a power electronic module is attached to a heat exchanger of the invention. In the cross-section of Figure 5 a power electronic module 50 is attached to the top surface of the base chamber of the heat exchanger. The power electronic module is shown to have a base plate 51 to which a substrate of the power electronic module is attached by a solder layer 52. The substrate of the example comprises copper layers 53, 55 and a ceramic layer 54. Further, the module has semiconductor chips 56 which produce the heat when operated. The module has further a housing 57 covering the inner structures. The base plate of the module and the top surface of the base chamber has a thermal interface material 58 layer between the two. It should be noted, that the use of the heat exchanger of the invention is not limited to a certain kind or type of component or module. Figure 5 is thus shown as an example of how a heat generating component is attached to the heat exchanger.

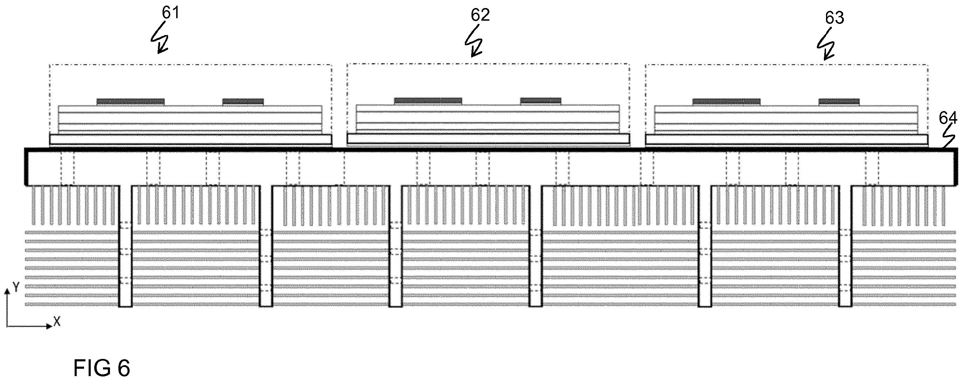

Figure 6 shows an embodiment of the heat exchanger of the present invention. In the embodiment the base chamber 64 is extended such that multiple of power electronic modules 61, 62, 63 can be attached to the top surface of the base chamber. Structurally the heat exchanger of Figure 6 corresponds to the ones described above. It should be noted, that when multiple of power electronic modules are cooled using a single heat exchanger, each of the modules run at substantially same temperature.

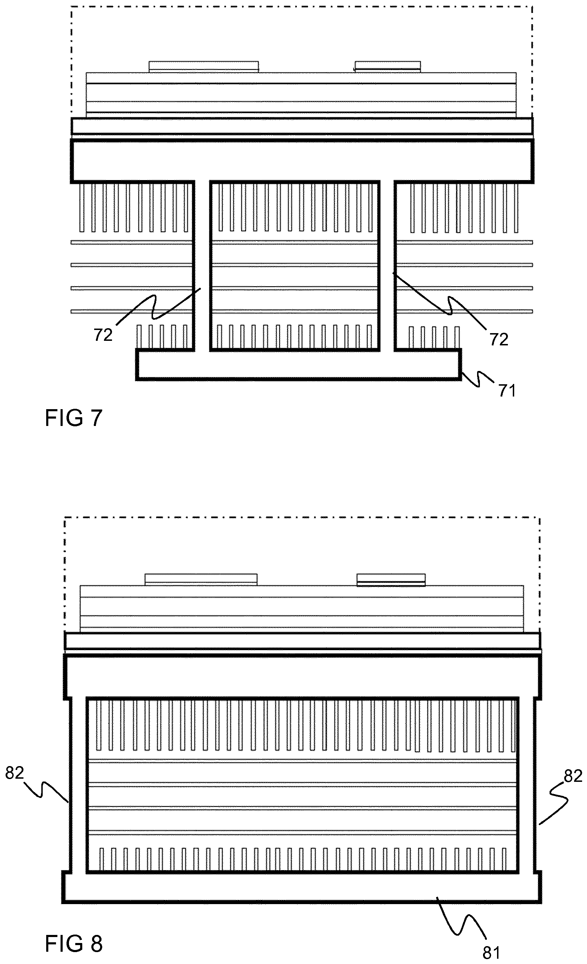

Figure 7 shows another embodiment of the invention in which the heat exchanger comprises further a bottom chamber 71 having one or more openings. Further, the one or more condensers 72 have a bottom opening and the bottom chamber 71 is attached to the one or more condensers 72 such that the openings of the condensers and the bottom chamber are aligned so that a closed gas-tight structure is formed of the base chamber, the one or more condensers and the bottom chamber. Thus in the embodiment, a bottom chamber is attached to the condensers and the working fluid can flow freely inside the structure which has an additional chamber when compared to the previous embodiment. As shown in Figure 7, additional cooling fins are attached to the bottom chamber. An advantage of the embodiment is that the additional bottom chamber balances the heat exchanger internal pressure effectively and enables more uniform operation in different orientations and higher cooling efficiency.

Figure 8 shows a modification of the embodiment of Figure 7. In the embodiment of Figure 8, the condensers 82 are situated near the sides of the base chamber and the bottom chamber 81. Figure 8 shows cooling fins extending inside the structure limited by the base chamber, condensers and the bottom chamber. The embodiment of Figure 8 has the same advantages as the embodiment of Figure 7. The bottom chamber is preferably attached to the one or more condensers by soldering or laser welding. The inner structure of the bottom chamber may include similar support structures and wick as other parts of the heat exchanger as described above.

The method is described above in connection with an embodiment in which the construction material is selected to be copper. However, the construction material is metal, and preferably copper, aluminum or titanium.

It will be obvious to a person skilled in the art that, as the technology advances, the inventive concept can be implemented in various ways. The invention and its embodiments are not limited to the examples described above but may vary within the scope of the claims.

## Claims

1. A heat-exchanger comprising
a base chamber (11) and one or more condensers (12), wherein
the base chamber (11) comprises a top surface (13), a bottom surface (14) and side walls (15) attached to the top surface and the bottom surface, the top surface being adapted to receive one or more heat generating components and the bottom surface comprising one or more elongated openings (16) and
the one or more condensers (12) are formed to the bottom surface (14) of the base chamber, extend from the bottom surface and are closed structures having an opening corresponding to the openings of the bottom surface such that the base chamber (11) forms together with the one or more condensers a gas-tight structure having a working fluid enclosed inside the volume of the structure.

2. A heat exchanger according to claim 1, wherein the one or more elongated openings of the bottom surface have a width and a length corresponding to the openings of the one or more condensers.

3. A heat exchanger according to claim 1 or 2, wherein the one or more condensers extend between opposite edges of the base chamber.

4. A heat exchanger according to claim 1, 2 or 3, wherein the one or more condensers extend from the bottom surface of the base chamber in the direction perpendicular to the top surface of the base chamber.

5. A heat exchanger according to any one of the previous claims 1 to 4, wherein the heat exchanger comprises further a bottom chamber having one or more openings, wherein the one or more condensers have a bottom opening and the one or more condensers are attached to the bottom chamber such that the bottom opening of the one or more condensers and the one or more opening of the bottom chamber are aligned, wherein a closed gas-tight structure is formed of the base chamber, the one or more condensers and the bottom chamber.

6. A heat exchanger according to any one of the previous claims 1 to 5, wherein the heat exchanger is a hermetically sealed structure having a working fluid enclosed inside the volume of the structure.

7. A heat exchanger according to any one of the previous claims 1 to 6, wherein the heat exchanger is of metal, such as copper, aluminum or titanium.

8. A heat exchanger according to any one of the previous claims 1 to 7, wherein the thickness of the one or more condensers is in the range of 1 mm to 3 mm.

9. A heat exchanger according to any one of the previous claims 1 to 8, wherein the wall thickness of the one or more condensers is in the range of 1 mm to 3 mm.

10. A heat exchanger according to any one of the previous claims 1 to 9, wherein the wall thickness of the top surface of the base chamber is in the range of 3 mm to 7 mm.

11. A method for manufacturing a heat exchanger comprising
providing a rectangular metal sheet,
providing supporting structures to a surface of the rectangular metal sheet,
forming the rectangular metal sheet to produce one or more condensers and a bottom surface of a base chamber,
providing a metal part forming a top surface and the side walls of the base chamber,
attaching the metal part to the formed rectangular metal sheet to form a closed structure, and
sealing the ends of the one or more condensers with metal sheets.

12. A method according to claim 11, wherein the metal is copper, aluminum or titanium.
